(19) Europäisches Patentamt

European Patent Office

Office européen des brevets

(11) Veröffentlichungsnummer: **0 422 730 A2**

# (12) EUROPÄISCHE PATENTANMELDUNG

(21) Anmeldenummer: **90202656.6**

(22) Anmeldetag: **05.10.90**

(51) Int. Cl.5: **H03M 1/12**

(30) Priorität: **10.10.89 AT 2341/89**

(43) Veröffentlichungstag der Anmeldung:
**17.04.91 Patentblatt 91/16**

(84) Benannte Vertragsstaaten:
**DE FR GB IT**

(71) Anmelder: **N.V. Philips' Gloeilampenfabrieken**
**Groenewoudseweg 1**
**NL-5621 BA Eindhoven(NL)**

(72) Erfinder: **Huber, Wolfgang**
**c/o INT. OCTROOIBUREAU B.V. Prof.**
**Holstlaan 6**
**NL-5656 AA Eindhoven(NL)**

(74) Vertreter: **van der Kruk, Willem Leonardus et**
**al**
**INTERNATIONAAL OCTROOIBUREAU B.V.**
**Prof. Holstlaan 6**
**NL-5656 AA Eindhoven(NL)**

(54) **Schaltungsanordnung mit einem Einstellregler.**

(57) Bei einer Schaltungsanordnung (1) mit einem Einstellregler (2), der zwei Endanschlüsse (3, 4) und einen zwischen den beiden Endanschlüssen (3, 4) verstellbaren Schleifer (5) zum Einstellen unterschiedlicher Widerstandsverhaltnisse aufweist, sind die beiden Endanschlüsse (3, 4) des Einstellreglers (2) je mit einem von zwei Anschlüssen (6, 7) eines Mikroprozessors (8) verbunden und der Schleifer (5) des Einstellreglers (2) mit einem Anschluss (17) loeines Kondensators (18) verbunden, dessen anderer Anschluss (19) mit einem vorgegebenen Potential (V2) verbunden ist. Mit jedem der beiden Anschlüsse (, 7) des Mikroprozessors (8) ist mindestens ein steuerbarer Schalter (11, 12) verbunden, mit dem wahlweise ein erstes Potential (V1) oder ein zweites Potential (V2) an den betreffenden Anschluss (6, 7) anschaltbar ist. Der Mikroprozessor (8) ist zur Durchführung eines Programmablaufes (20) ausgebildet, bei dem der zuvor jeweils in einen Ausgangsladezustand gebrachte Kondensator (18) zuerst über einen Widerstandsteil (RI) und danach über den anderen Widerstandsteil (R2) des Einstellreglers (2) umgeladen wird, wobei jeweils ein einer Umladezeitspanne (TU1, TU2) entsprechender Messwert (Z(Z2), Z(Z3)) ermittelt wird und aus den ermittelten Messwerten (Z(Z2), Z(Z3)) durch Quotientenbildung ein digitales Datenwortsignal (SQ) erzeugt wird, das das jeweils eingestellte Widerstandsverhältnis repräsentiert.

FIG.1

## SCHALTUNGSANORDNUNG MIT EINEM EINSTELLREGLER

Die Erfindung betrifft eine Schaltungsanordnung mit einem Einstellregler, der zwei Endanschlüsse und einen zwischen den beiden Endanschlüssen verstellbaren Schleifer zum Einstellen unterschiedlicher Widerstandsverhältnisse aufweist, mit der ein ein mit dem Schleifer eingestelltes Widerstandsverhältnis repräsentierendes elektrisches Signal erzeugbar ist.

Es ist beispielsweise eine solche Schaltungsanordnung allgemein bekannt, bei der ein Einstellregler mit seinen beiden Endanschlüssen an eine Gleichspannungsquelle angeschaltet ist, wobei ein Endanschluß mit einem vorgegebenen Versorgungspotential und der andere Endanschluß mit einem Bezugspotential, beispielsweise Massepotential, verbunden ist, und bei der über den Schleifer des Einstellreglers ein ein mit dem Schleifer eingestelltes Widerstandsverhältnis repräsentierender Gleichspannungswert abgegriffen wird, der dem jeweiligen Spannungsteilerverhältnis entspricht. Bei einer solchen Schaltungsanordnung ist das elektrische Signal, das ein mit dem Schleifer eingestelltes Widerstandsverhältnis repräsentiert, durch einen Gleichspannungswert, also durch ein analoges Signal gebildet. Aufgrund der ständig zunehmenden Bedeutung der digitalen Signalverarbeitung besteht aber in zunehmendem Maße das Bedürfnis an Schaltungsanordnungen mit einem einen Schleifer aufweisenden Einstellregler, bei denen das Signal, das ein mit dem Schleifer eingestelltes Widerstandsverhältnis repräsentiert, durch ein digitales Signal gebildet ist, um das ein eingestelltes Widerstandsverhältnis repräsentierende Signal auf digitale Weise verarbeiten zu können, beispielsweise mit einem Mikroprozessor, der mit der den Einstellregler enthaltenden Schaltungsanordnung zusammenwirkt. Um ein solches digitales Signal, das ein eingestelltes Widerstandsverhältnis des Einstellreglers repräsentiert, zu erhalten, kann bei der bekannten Schaltungsanordnung der vom Schleifer des Einstellreglers abgegriffene Gleichspannungswert einer separaten Analog/Digital-Wandlerschaltung zugeführt werden, die diesen Gleichspannungswert in ein digitales Datenwortsignal umwandelt. Eine solche Realisierung erfordert aber eine separate Analog/Digital-Wandlerschaltung, die einen zusätzlichen Aufwand darstellt und die relativ teuer ist, wenn sie für eine möglichst genaue Analog/Digital-Wandlung ausgebildet ist.

Die Erfindung hat sich zur Aufgabe gestellt, das vorstehend erwähnte Bedürfnis zufriedenzustellen und eine Schaltungsanordnung der eingangs angeführten Gattung zu schaffen, die einfach und preiswert ausgebildet ist und mit der auf einfache und genaue Weise ein ein mit dem Schleifer eingestelltes Widerstandsverhältnis repräsentierendes digitales Signal erzeugbar ist. Hiefür ist die Erfindung dadurch gekennzeichnet, daß die beiden Endanschlüsse des Einstellreglers je mit einem von zwei Anschlüssen eines Mikroprozessors verbunden sind und der Schleifer des Einstellreglers mit einem Anschluß eines Kondensators verbunden ist, dessen anderer Anschluß mit einem vorgegebenen Potential verbunden ist, und daß mit jedem der beiden Anschlüsse des Mikroprozessors mindestens ein durch den Mikroprozessor steuerbarer Schalter verbunden ist, mit dem wahlweise ein erstes Potential oder ein zweites Potential an den mit ihm verbundenen Anschluß anschaltbar ist, und daß der Mikroprozessor zur Durchführung eines programmablaufes ausgebildet ist, bei dem aufeinanderfolgend in einem ersten Programmabschnitt an mindestens einen der beiden Anschlüsse mit dem mit diesem verbundenen Schalter eines von dem ersten und zweiten Potential für eine vorgegebene Zeitspanne angeschaltet wird, wobei der Kondensator in einen Ausgangsladezustand gebracht wird, in einem zweiten Programmabschnitt an einen der beiden Anschlüsse mit dem mit diesem verbundenen Schalter das andere von dem ersten und zweiten Potential zum Umladen des Kondensators über den zwischen diesem einen Anschluß und dem Schleifer liegenden einen Widerstandsteil des Einstellreglers angeschaltet wird und ein erster Meßwert ermittelt und gespeichert wird, der einer zum Wert dieses einen Widerstandsteiles proportionalen ersten Umladezeitspanne vom Startzeitpunkt des Umladens bis zu einem Zeitpunkt, zu dem das Potential an dem mit dem Schleifer verbundenen Anschluß des Kondensators einen vorgegebenen Potentialwert erreicht, entspricht, in einem dritten Programmabschnitt an mindestens einen der beiden Anschlüsse mit dem mit diesem verbundenen Schalter wieder das eine von dem ersten und zweiten Potential für die vorgegebene Zeitspanne angeschaltet wird, wobei der Kondensator wieder in den Ausgangsladezustand gebracht wird, in einem vierten Programmabschnitt an den anderen der beiden Anschlüsse mit dem mit diesem verbundenen Schalter das andere von dem ersten und zweiten Potential zum Umladen des Kondensators über den zwischen diesem anderen Anschluß und dem Schleifer liegenden anderen Widerstandsteil des Einstellreglers angeschaltet wird und ein zweiter Meßwert ermittelt und gespeichert wird, der einer zum Wert dieses anderen Widerstandsteiles proportionalen zweiten Umladezeitspanne vom Startzeitpunkt des Umladens bis zu einem Zeitpunkt, zu dem das Potential an dem mit dem Schleifer verbundenen Anschluß des Kondensators wieder den vorgegebenen Potentialwert erreicht, entspricht, und in einem fünften Programmabschnitt unter Verwendung des gespeicherten ersten Meßwertes und des gespeicherten zweiten Meßwertes durch Quotientenbildung ein digitales Datenwortsignal erzeugt und gespeichert wird, das ein mit dem Schleifer des Einstellreglers eingestelltes Widerstandsverhältnis repräsentiert.

Auf diese Weise ist eine Schaltungsanordnung mit einem einen verstellbaren Schleifer aufweisenden Einstellregler geschaffen, mit der ein ein mit dem Schleifer eingestelltes Widerstandsverhältnis repräsentierendes digitales Signal erzeugbar ist und die eine einfache und preiswerte Ausbildung aufweist, weil ein zur Realisierung einer Vielzahl von weiteren Aufgaben in einem Gerät beziehungsweise in einer Einrichtung ohnehin vorgesehener Mikroprozessor zusätzlich zur Erzeugung des ein eingestelltes Widerstandsverhältnis repräsentierenden digitalen Signales ausgenützt wird. Das Erzeugen dieses digitalen Signales kann vorteilhafterweise in kurzen Zeitabständen auf einanderfolgend, beispielsweise in Zeitabständen von 50msec oder auch weniger, stets aufs Neue erfolgen, so daß bei jeder Verstellung des Schleifers des Einstellreglers praktisch sofort ein das soeben eingestellte Widerstandsverhältnis repräsentierendes digitales Signal erzeugt wird. Das im Mikroprozessor erzeugte und gespeicherte, ein eingestelltes Widerstandsverhältnis repräsentierende digitale Signal steht dabei für beliebig lange Zeiträume unverändert zur Verfügung und kann jederzeit, somit vorteilhafter weise auch in kurzen Zeitabständen auf einanderfolgend wiederholt für hiefür vorgesehene Zwecke abgerufen werden. Beispielsweise kann eine solche erfindungsgemäße Schaltungsanordnung mit einem Einstellregler Bestandteil einer zumindest teilweise in digitaler Technik unter Ausnützung des Mikroprozessors realisierten Motorregelschaltung sein, bei der der Einstellregler zum Einstellen eines Geschwindigkeits- beziehungsweise Drehzahl-Sollwertes eines in seiner Drehzahl regelbaren Motors vorgesehen ist. Eine solche erfindungsgemäße Schaltungsanordnung kann aber auch bei vielen anderen hauptsächlich in digitaler Technik realisierten Einrichtungen vorteilhaft verwendet werden, wie etwa bei Fernsteuereinrichtungen, bei Computerspieleinrichtungen oder dergleichen. An dieser Stelle sei noch festgehalten, daß unter einem Einstellregler sowohl ein Drehpotentiometer als auch ein Schieberegler zu verstehen ist, bei denen die Schleiferverstellung auf beliebige Weise erfolgen kann, beispielsweise von Hand aus mit oder ohne einem Werkzeug oder auch mit Hilfe eines Motors.

Um den Kondensator jeweils in seinen Ausgangsladezustand zu bringen, kann im ersten und dritten Programmabschnitt an jeweils nur einen der Anschlüsse des Mikroprozessors mit dem mit diesem Anschluß verbundenen Schalter das eine von dem ersten und zweiten Potential für eine vorgegebene Zeitspanne angeschaltet werden. Dabei muß aber dann eine relativ lange Zeitspanne gewählt werden, um den Kondensator mit Sicherheit in seinen Ausgangsladezustand zu bringen. Als vorteilhaft hat sich daher erwiesen, wenn der Mikroprozessor zur Durchführung eines Programmablaufes ausgebildet ist, bei dem in dem ersten Programmabschnitt und in dem dritten Programmabschnitt an beide Anschlüsse des Mikroprozessors mit den mit diesen Anschlüssen verbundenen Schaltern das eine von dem ersten und zweiten Potential für eine vorgegebene Zeitspanne angeschaltet wird, wobei der Kondensator in seinen Ausgangsladezustand gebracht wird. Auf diese Weise ist erreicht, daß der Kondensator in einer relativ kurzen Zeitspanne mit Sicherheit in seinen Ausgangsladezustand gebracht wird, was hinsichtlich eines möglichst raschen Erzeugens des das eingestellte Widerstandsverhältnis repräsentierenden digitalen Signales vor teilhaft ist.

Mit jedem der beiden mit den Endanschlüssen des Einstellreglers verbundenen Anschlüsse des Mikroprozessors können zwei Schalter verbunden sein, wobei über einen Schalter eines von dem ersten und zweiten, Potential und über den anderen Schalter das andere von dem ersten und zweiten Potential an den mit den beiden Schaltern verbundenen Anschluß anschaltbar ist. Als vorteilhaft hat sich aber erwiesen, wenn die beiden Endanschlüsse des Einstellreglers je über einen Widerstand an eines von dem ersten und zweiten Potential fix angeschlossen sind und an jeden der beiden mit den Endanschlüssen verbundenen Anschlüsse des Mikroprozessors über nur einen Schalter je Anschluß das andere von dem ersten und zweiten Potential anschaltbar ist. Auf diese Weise ist erreicht, daß für jeden der beiden Anschlüsse des Mikroprozessors mit nur je einem Schalter das Auslangen gefunden wird.

Die mit den beiden Anschlüssen des Mikroprozessors verbundenen steuerbaren Schalter können durch extern an den Mikroprozessor angeschlossene Schalter; beispielsweise durch diskrete Schalttransistoren oder durch integrierte Analogschalter, gebildet sein. Als vorteilhaft hat sich aber erwiesen, wenn die mit den beiden Anschlüssen des Mikroprozessors verbundenen Schalter durch mikroprozessorinterne Transistoren gebildet sind. Hiedurch wird eine besonders einfache Ausbildung erhalten, bei der in handelsüblichen Mikroprozessoren ohnehin enthaltene Transistoren zur Durchführung von in einer erfindungsgemäßen Schaltungsanordnung erforderlichen Schaltvorgängen ausgenützt werden.

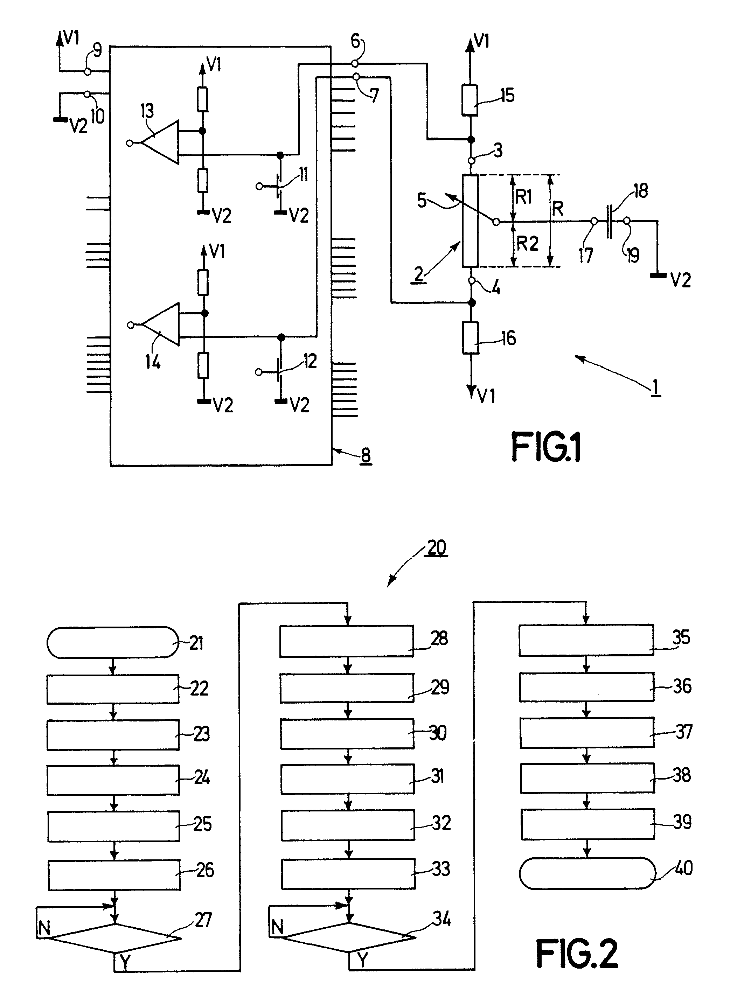

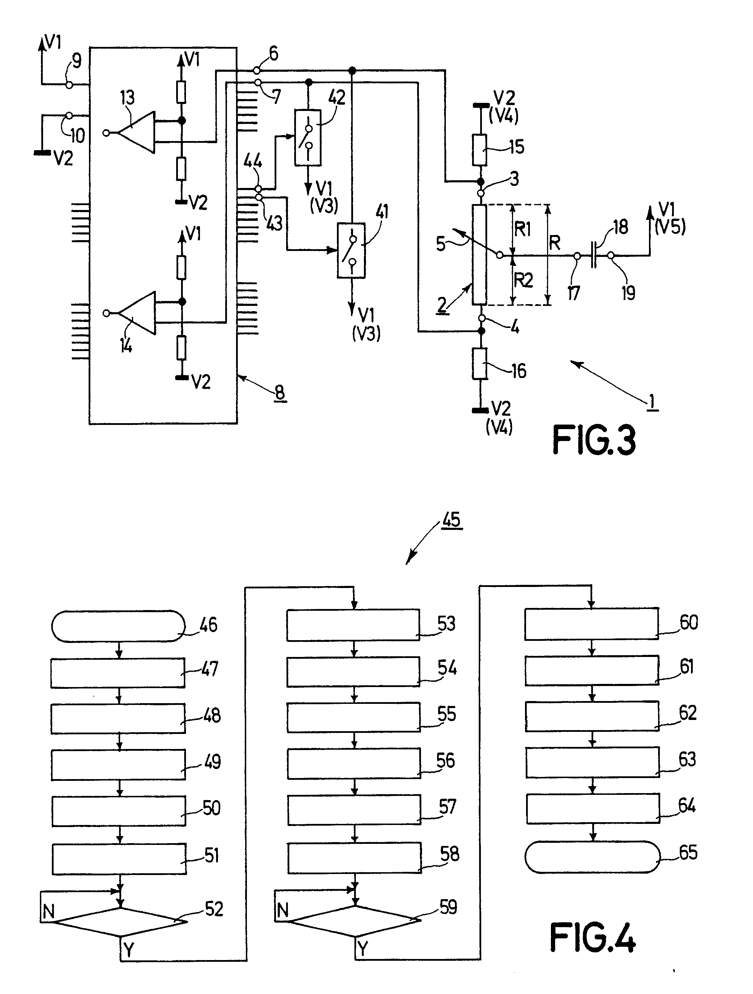

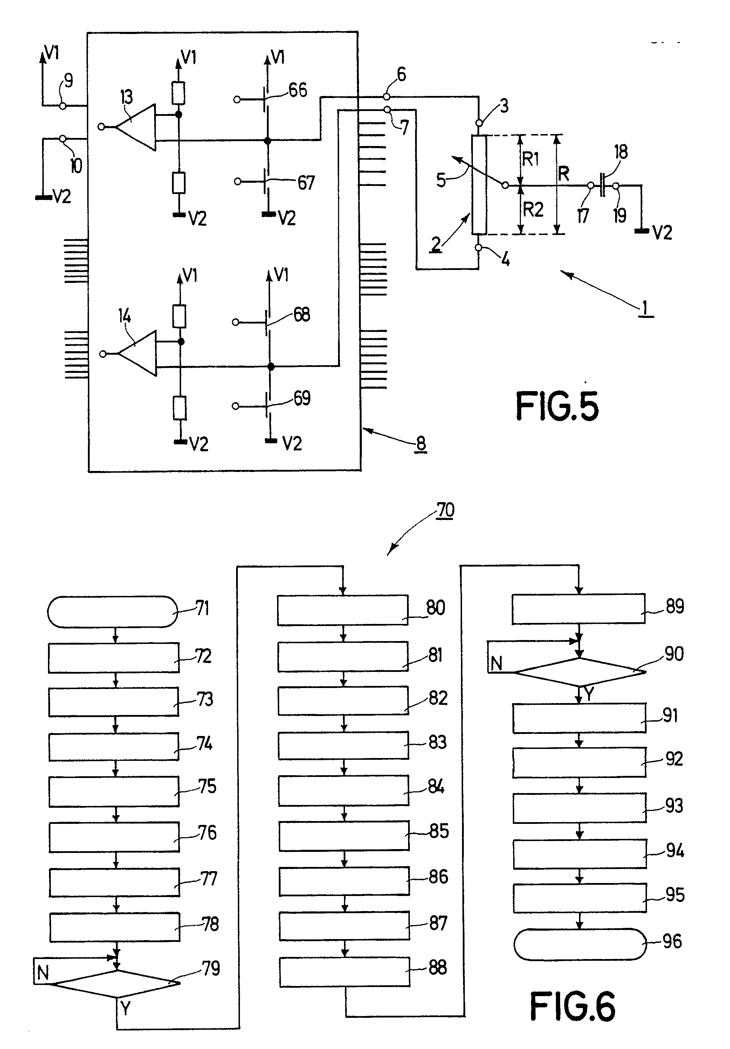

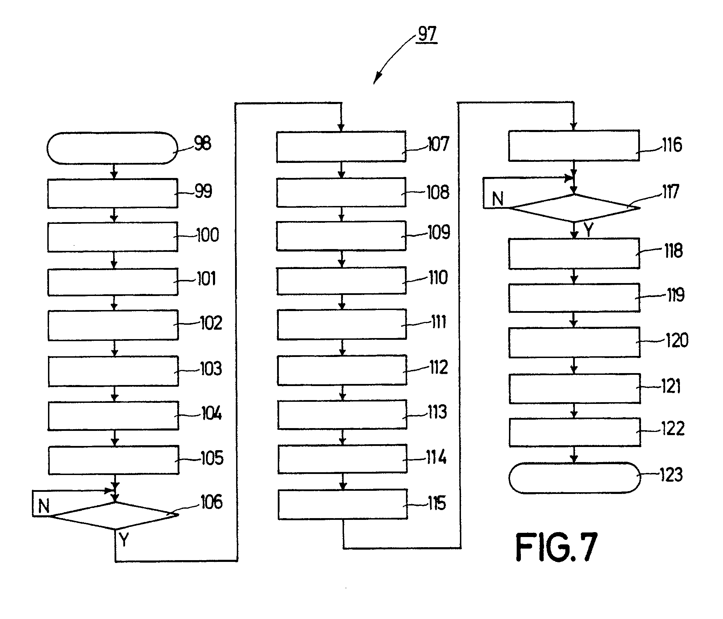

Die Erfindung wird im folgenden anhand von einigen in den Zeichnungen dargestellten Ausführungsbeispielen, auf die sie jedoch nicht beschränkt sein soll, näher beschrieben. Die Fig.1 zeigt eine Schaltungsanordnung gemäß einem ersten Ausführungsbeispiel mit einem Einstellregler, dessen Endanschlüsse mit zwei bidirektional verwendbaren Anschlüssen eines Mikroprozessors verbunden sind, die je über einen mikroprozessorinternen Schalter mit einem Bezugspotential verbindbar sind, wobei die Endanschlüsse des Einstellreglers je über einen Widerstand mit einem Versorgungspotential verbunden sind. Die Fig.2 zeigt ein Flußdiagramm eines Programmab laufes, der in dem Mikroprozessor der Schaltungsanordnung gemäß Fig.1 abgearbeitet wird, um ein digitales Signal zu erzeugen, das ein mit dem Schleifer des Einstellreglers eingestelltes Widerstandsverhältnis repräsentiert. Die Fig.3 zeigt Seine Schaltungsanordnung gemäß einem zweiten Ausführungsbeispiel mit einem Einstellregler, dessen Endanschlüsse mit zwei unidirektional verwendbaren Anschlüssen eines Mikroprozessors verbunden sind, die je mit einem gegenüber dem Mikroprozessor externen Schalter verbunden sind, über die die beiden Anschlüsse des Mikroprozessors an ein Versorgungspotential anschaltbar sind, wobei die Endanschlüsse des Einstellreglers über je einen Widerstand mit einem Bezugspotential verbunden sind. Die Fig.4 zeigt ein Flußdiagramm eines Programmablaufes, der in dem Mikroprozessor der Schaltungsanordnung gemäß Fig.3 abgearbeitet wird, um ein digitales Signal zu erzeugen, das ein mit dem Schleifer des Einstellreglers eingestelltes Widerstandsverhältnis repräsentiert. Die Fig.5 zeigt eine Schaltungsanordnung gemäß einem dritten Ausführungsbeispiel mit einem Eintellregler, dessen beide Endanschlüsse mit zwei bidirektional verwendbaren Anschlüssen eines Mikroprozessors verbunden sind, die je über zwei mikroprozessorinterne Schalter entweder mit einem Versorgungspotential oder mit einem Bezugspotential verbindbar sind. Die Fig.6 zeigt ein Flußdiagramm eines Programmablaufes, der in dem Mikroprozessor der Schaltungsanordnug gemäß Fig.5 abgearbeitet wird, um ein digitales Signal zu erzeugen, das ein mit dem Schleifer des Einstellreglers eingestelltes Widerstandsverhältnis repräsentiert. Die Fig.7 zeigt ein Flußdiagramm eines weiteren Programmablaufes, der bei entsprechender anderer Ausbildung in dem Mikroprozessor der Schaltungsanordnung gemäß Fig.5 abgearbeitet werden kann, um ein digitales Signal zu erzeugen, das ein mit dem Schleifer des Einstellreglers eingestelltes Widerstandsverhältnis repräsentiert.

In Fig.1 ist eine Schalungsanordnung 1 gemäß einem ersten Ausführungsbeispiel dargestellt, die einen Einstellregler 2 aufweist, der beispielsweise als Drehpotentiometer ausgebildet ist. Der Einstellregler 2 weist zwei Endanschlüsse 3 und 4 auf. Weiters weist der Einstellregler 2 einen zwischen den beiden Endanschlüssen 3 und 4 verstellbaren Schleifer 5 zum

Einstellen unterschiedlicher Widerstandsverhältnisse auf. Wie in Fig.1 angegeben ist, weist der Einstellregler 2 einen zwischen seinen beiden Endanschlüssen 3 und 4 liegenden Gesamtwiderstandswert R auf. Mit dem Schleifer 5 sind je nach Stellung desselben unterschiedliche Widerstandverhältnisse einstellbar, so daß zwischen dem einen Endanschluß 3 und dem Schleifer 5 ein Widerstandsteil R1 und zwischen dem anderen Endanschluß 4 und dem Schleifer 5 ein Widerstandsteil R2 liegt.

Mit der Schaltungsanordnung 1 ist ein ein mit dem Schleifer 5 des Einstellreglers 2 eingestelltes Widerstandsverhältnis repräsentierendes digitales Signal erzeugbar. Hiefür sind nunmehr die beiden Endanschlüsse 3 und 4 des Einstellreglers 2 je mit einem von zwei Anschlüssen 6 und 7 eines Mikroprozessors 8 verbunden. Bei diesen beiden Anschlüssen 6 und 7 handelt es sich um bidirektional verwendbare Signalanschlüsse, die sowohl als Eingänge als auch als Ausgänge verwendbar sind. An den Mikroprozessor 8 sind zu dessen Spannungsversorgung über zwei weitere Anschlüsse 9 und 10, bei denen es sich um Versorgungsanschlüsse handelt, ein erstes Potential V1 und ein zweites Potential V2 angeschaltet, wobei es sich bei dem ersten Potential V1 um ein Versorgungspotential und bei dem zweiten Potential V2 um ein Bezugspotential, nämlich Massepotential, handelt. Bei dem Mikroprozessor 8 kann es sich beispielsweise um einen von der Anmelderin hergestellten, im Handel unter der Typenbezeichnung PCB80C51 erhältlichen Mikroprozessor handeln, der zum Anschließen an ein Versorgungspotential von +5Volt ausgebildet ist. Der Mikroprozessor 8 weist noch eine Reihe weiterer, schematisch angedeuteter Anschlüsse auf, auf die aber hier nicht näher eingegangen wird, weil diese in vorliegendem Zusammenhang keine Funktion aufweisen.

Mit den beiden Anschlüssen 6 und 7 der Mikroprozessors 8 ist je ein durch den Mikroprozessor 8 steuerbarer Schalter 11 bzw. 12 verbunden, mit dem wahlweise das erste Potential V1 oder das zweite Potential V2 an den mit ihm verbundenen Anschluß 6 bzw. 7 des Mikroprozessors 8 anschaltbar ist, was nachfolgend noch näher erläutert ist. Die beiden Schalter 11 und 12 sind hiebei auf einfache Weise je durch einen mikro prozessorinternen Transistor gebildet, wie dies in Fig.1 schematisch angedeutet ist. Jeder dieser Transistoren 11 bzw. 12 ist mit seiner Hauptstromstrecke einerseits an den betreffenden Anschluß 6 bzw. 7 des Mikroprozessors 8 und andererseits an das zweite Potential V2 angeschlossen. Zum Ansteuern jedes Transistors 11 bzw. 12 ist dessen Steuerelektrode ein entsprechendes Steuersignal zuführbar, das im Mikroprozessor 8 erzeugt wird. Mit den Anschlüssen 6 und 7 ist weiters je ein Eingang eines mikroprozessorinternen Spannungskomparators 13 bzw. 14 verbunden, dessen anderem Eingang über einen zwischen dem ersten Potential V1 und dem zweiten Potential V2 liegenden Spannungsteiler ein Referenzpotential zugeführt wird. Das Referenzpotential liegt beispielsweise auf dem Wert V1/2 , wobei jeder Komparator 13 bzw. 14 an seinem Ausgang dann ein Detektionssignal abgibt, wenn das an dem mit einem Anschluß 6 bzw. 7 verbundenen Eingang auftretende Potential den Potentialwert V1/2 erreicht. Das Referenzpotential könnte aber auch einen anderen Potentialwert als V1/2 aufweisen.

Die beiden Endanschlüsse 3 und 4 des Einstellreglers 2 sind je über einen Widerstand 15 bzw. 16 an das erste Potential V1 fix angeschlossen. Die beiden Widerstände 15 und 16 weisen zweckmäßigerweise denselben Widerstandswert auf, der günstigerweise zumindest um eine Größenordnung größer als der Widerstandswert R des Einstellreglers 2 ist. Durch Öffnen der Schalter 11 und 12, wenn also die Transistoren in ihren nichtleitenden Zustand gesteuert sind, wird über die Widerstände 15 und 16 das erste Potential V1 an die Anschlüsse 6 und 7 des Mikroprozessors 8 und damit auch an die Endanschlüsse 3 und 4 des Einstellreglers 2 angeschaltet. Durch Schließen der Schalter 11 und 12, wenn also die Transistoren in ihren leitenden Zustand gesteuert sind, wird über die Schalter 11 und 12 das zweite Potential V2 an die Anschlüsse 6 und 7 des Mikroprozessors 8 und damit auch an die Endanschlüsse 3 und 4 des Einstellreglers 2 angeschaltet.

Der Schleifer 5 des Einstellreglers 2 ist mit einem Anschluß 17 eines Kondensators 18 verbunden. Der andere Anschluß 19 des Kondensators 18 ist mit einem vorgegebenen Potential verbunden, das in vorliegendem Falle durch das zweite Potential V2, also Massepotential, gebildet ist. Der Anschluß 19 des Kondensators 18 könnte aber auch an ein vom Massepotential abweichendes Potential angeschlossen sein.

Wie bereits erwähnt, ist mit der Schaltungsanordnung 1 ein das jeweils Eingestellte Widerstandsverhältnis repräsentierendes digitales Signal erzeugbar. Zur Erzeugung dieses Signales ist der Mikroprozessor 8 zur Durchführung eines Programmablauf es ausgebildet, der im folgenden anhand des in Fig.2 dargestellten Flußdiagrammes 20 beschrieben ist.

Beim Block 21 wird dieser Programmablauf gestartet. Beim nachfolgenden Block 22 wird der Schalter 11 in seinen nichtleitenden Zustand gesteuert, wodurch an den einen Anschluß 6 des Mikroprozessors 8 und an den einen Endanschluß 3 des Einstellreglers 2 über den Widerstand 15 das erste Potential V1 angeschaltet wird. Danach wird beim Block 23 der Schalter 12 ebenfalls in seinen nichtleitenden Zustand gesteuert, wodurch an den anderen Anschluß 7 des Mikroprozessors 8 und an den anderen Endanschluß 4 des Einstellreglers 2 über den Widerstand 16 das erste Potential V1 angeschaltet wird. Danach wird beim Block 24 ein interner Zeitgeber Z1 gestartet, der durch Zählen bis zu einem vorgegebenen Zählwert gewährleistet, daß die durch die Programmschritte bei den Blöcken 22 und 23 erzeugten Zustände für eine dem vorgegebenen Zählwert entsprechende vorgegebene Zeitspanne T1 erhalten bleiben und erst nach Ablauf der vorgegebenen Zeitspanne T1 die Durchführung des nächsten Programmschrittes beim Block 25 freigegeben wird. Durch das Anschalten des ersten Potentiales V1 an die beiden Endanschlüsse 3 und 4 des Eintellreglers 2 wird der Kondensator 18 sowohl über den Widerstand 15 und den einen Widerstandsteil R1 als auch über den Widerstand 16 und den anderen Widerstandsteil R2 relativ rasch geladen, wobei das Potential an dem mit dem Schleifer 5 verbundenen Anschluß 17 des Kondensators 18 steigt. Hiedurch wird der Kondensator 18 in einen Ausgangsladezustand gebracht, in dem derselbe geladen ist. Die vorgegebene Zeitspanne T1 ist dabei so gewählt, daß der Kondensator 18 mit Sicherheit in seinen Ausgangslade zustand gebracht wird.

Nach Ablauf der vorgegebenen Zeitspanne T1 wird beim Block 25 der Schalter 11 in seinen leitenden Zustand gesteuert, wo durch an den einen Anschluß 6 des Mikroprozessors 8 und an den einen Endanschluß 3 des Einstellreglers 2 das zweite Potential V2 angeschaltet wird, dies zum Umladen des Kondensators 18 über den zwischen diesem einen Anschluß 6 und dem Sschleifer 5 liegenden einen Widerstandsteil R1 des Einstellreglers 2 und den nunmehr leitenden Schalter 11. In vorliegendem Fall wird durch dieses Umladen des Kondensators 18 dieser entladen, wobei das Potential an seinem mit dem Schleifer 5 verbundenen Anschluß 17 sinkt. Während dieses Entladevorganges des Kondensators 18 wird derselbe, da sich der Schalter 12 in seinem nichtleitenden Zustand befindet, über den Widerstand 16 und den anderen Widerstandsteil R2 zwar an sich auch geladen, jedoch ist aufgrund des großen Widerstandswertes des Widerstandes 16 dieser Einfluß vernachlässigbar. Beim nachfolgenden Block 26 wird ein Zeitzähler Z2 gestartet, dies bedeutet, daß dieser Zeitzähler Z2 praktisch zu dem beim vorhergehenden Block 25 ausgelösten Startzeitpunkt des Umladens des Kondensators 18, gestartet wird. Danach wird beim Block 27 geprüft, ob das an dem anderen Anschluß 7 des Mikroprozessors 8 auftretende Potential, das hiebei im wesentlichen dem Potential an dem mit dem Schleifer 5 verbundenen Anschluß 17 des Kondensators 18 entspricht, das vorgegebene Referenzpotential V1/2 erreicht hat. Diese Überprüfung erfolgt mit Hilfe des mit dem anderen Anschluß 7 verbundenen Komparators 14. Solange dies nicht der Fall ist und das Potential an dem anderen Anschluß 7 höher als das Referenzpotential V1/2 ist) wird der Programmablauf beim Block 27 fortgesetzt. Wenn das Potential an dem anderen Anschluß 7 den Wert V1/2 erreicht hat, gibt der Komparator 14 ein Detektionssignal an seinem Ausgang ab, was einem positiven Prüfungsergebnis beim Block 27 entspricht. Hierauf wird der Programmablauf beim Block 28 fortgesetzt, bei dem der Zeitzähler Z2 gestoppt wird, der dann einen bestimmten Zählerstand Z(Z2) aufweist. Danach wird beim Block 29 der Zählerstand Z(Z2) des Zeitzählers Z2 in einem Register RG1 gespeichert. Der gespeicherte Zählerstand Z(Z2) stellt einen ersten Meßwert dar. Dieser erste Meßwert entspricht einer zum Widerstandswert des einen Widerstandsteiles R1 und dem Kapazitätswert des Kondensators 18 proportionalen ersten Umladezeitspanne TU1 von dem beim Block 25 ausgelösten Startzeitpunkt des Umladens bis zu einem Zeitpunkt, zu dem das Potential an dem mit dem Schleifer 5 verbundenen Anschluß 17 des Kondensators 18 den vorgegebenen Potentialwert V1/2 erreicht hat.

Beim nachfolgenden Block 30 wird der Schalter 11 wieder in seinen nichtleitenden Zustand gesteuert, wodurch an den einen Anschluß 6 des Mikroprozessors 8 und an den einen Endanschluß 3 des Einstellreglers 2 über den Widerstand 15 wieder das erste Potential V1 angeschaltet wird. Da hiebei der andere Schalter 12 sich ebenfalls in seinem nichtleitenden Zustand befindet, wodurch an den anderen Anschluß 7 des Mikroprozessors 8 und an den anderen Endanschluß 4 des Einstellreglers 2 über den Widerstand 16 ebenfalls das erste Potential V1 angeschaltet ist, wird analog wie bei den Blöcken 22 und 23 der Kondensator 18 relativ rasch geladen, wobei das Potential an dem mit dem Schleifer 5 verbundenen Anschluß 17 des Kondensators 18 steigt. Hiedurch wird der Kondensator 18 wieder in seinen Ausgangsladezustand gebracht, in dem derselbe geladen ist. Beim nachfolgenden Block 31 wird analog wie beim Block 24 der interne Zeitgeber Z1 gestartet, durch den wieder gewährleistet ist, daß erst nach Ablauf der vorgegebenen Zeitspanne T1 die Durchführung des nächsten Programmschrittes beim Block 32 freigegeben wird.

Nach Ablauf der vorgegebenen Zeitspanne T1 wird beim Block 32 der Schalter 12 in seinen leitenden zustand gesteuert, wodurch an den anderen Anschluß 7 des Mikroprozessors 8 und an den anderen Endanschluß 4 des Einstellreglers 2 das zweite Potential V2 angeschaltet wird, dies zum Umladen des Kondensators 18 über den zwischen diesem anderen Anschluß 7 und dem Schleifer 5 liegenden anderen Widerstandsteil R2 des Einstellreglers 2 und den nunmehr leitenden Schalter 12. Hiedurch wird der Kondensator 18 wieder entladen, wobei das Potential an seinem mit dem Schleifer 5 verbundenen Anschluß 17 sinkt. Während dieses Entladevorgangs des Kondensators 18 wird derselbe, da sich der Schalter 11 in seinem nichtleitenden Zustand befindet, über den Widerstand 15 und den einen Widerstandsteil R1 zwar an sich auch geladen, jedoch ist aufgrund des großen Widerstandswertes des Widerstandes 15 dieser Einfluß vernachlässigbar. Beim nachfolgenden Block 33 wird ein Zeitzähler Z3 gestartet, dies bedeutet, daß dieser Zeitzähler Z3 praktisch zu dem beim vorhergehenden Block 32 ausgelösten Startzeitpunkt des Umladens des Kondensators 18 gestartet wird. Danach wird beim Block 34 geprüft, ob das an Sdem einen Anschluß 6 des Mikroprozessors 8 auftretende Potential, das hiebei ebenfalls im wesentlichen dem Potential an dem mit dem Schleifer 5 verbundenen Anschluß 17 des Kondensators 18 entspricht, das vorgegebene Referenzpotential V1/2 erreicht hat. Diese Überprüfung erfolgt mit Hilfe des mit dem einen Anschluß 6 verbundenen Komparators 13. Solange das Referenzpotential V1/2 nicht erreicht ist und das Potential an dem einen Anschluß 6 höher als das Referenzpotential V1/2 ist, wird der Programmablauf beim Block 34 fortgesetzt. Wenn aber das Potential an dem einen Anschluß 6 des Mikroprozessors 8 den Wert V1/2 erreicht hat, gibt der Komparator 13 ein Detektionssignal ab, was einem positiven Prüfungsergebnis beim Block 34 entspricht. Hierauf wird der Programmablauf beim Block 35 fortgesetzt, bei dem der Zeitzähler Z3 gestoppt wird, der dann einen bestimmten Zählerstand Z(Z3) aufweist. Danach wird beim Block 36 der Zählerstand Z(Z3) des Zeitzählers Z3 in einem Register RG2 gespeichert. Der gespeicherte Zählerstand Z(Z3) stellt einen zweiten Meßwert dar. Dieser zweite Meßwert entspricht einer zum Widerstandswert des anderen Widerstandsteiles R2 und dem Kapazitätswert des Kondensators 18 proportionalen zweiten Umladezeitspanne TU2 von dem beim Block 32 ausgelösten Startzeitpunkt des Umladens bis zu einem Zeitpunkt, zu dem das Potential an dem mit dem Schleifer 5 verbundenen Anschluß 17 des Kondensators 18 den vorgegebenen Potentialwert V1/2 erreicht hat. Beim nachfolgenden Block 37 wird der Schalter 12 wieder in seinen nichtleitenden Zustand gesteuert, wodurch an den anderen Anschluß 7 des Mikroprozessors 8 über den Widerstand 16 wieder das erste Potential V1 angeschaltet wird.

Beim nachfolgenden Block 38 wird unter Verwendung des beim Block 29 im Register RG1 gespeicherten ersten Meßwertes Z(Z2) und des beim Block 36 im Register RG2 gespeicherten zweiten Meßwertes Z(Z3) durch Quotientenbildung aus dem ersten Meßwert Z(Z2) und dem zweiten Meßwert Z(Z3) ein digitales Datenwortsignal SQ erzeugt. Beim nachfolgenden Block 39 wird das erzeugte digitale Datenwortsignal SQ in einem Register RG3 gespeichert. Dieses digitale Datenwortsignal SQ, das in vorliegendem Fall mit Hilfe des Quotienten aus dem zu dem einen Widerstandsteil R1 proportionalen ersten Meßwert Z(Z2) und dem zu dem anderen Widerstandsteil R2 proportionalen zweiten Meßwert Z(Z3) erzeugt wurde, repräsentiert das mit dem Schleifer 5 eingestellte Widerstandsverhältnis R1:R2 zwischen dem einen Widerstandsteil R1 und dem anderen Widerstandsteil R2 des Einstellreglers 2. Der Wert dieses digitalen Datenwortsignales SQ ist dabei aufgrund der Quotientenbildung vorteilhafterweise unabhängig von dem Kapazitätswert des Kondensators 18 und auch unabhängig vom Gesamtwiderstandswert R des Einstellreglers 2. Beim nachfolgenden Block 40 wird der Programmablauf 20 gemäß Fig.2 beendet.

Bei der Schaltungsanordnung 1 gemäß Fig.1 kann der Mikroprozessor 8 auch zur Durchführung eines Programmablauf es ausgebildet sein, bei dem beim Block 38 unter Verwendung der beiden gespeicherten Meßwerte Z(Z2) und Z(Z3) durch Quotientenbildung aus dem ersten Meßwert Z(Z2) und der Summe der beiden Meßwerte Z(Z2) und Z(Z3) beziehungsweise durch Quotientenbildung aus dem zweiten Meßwert Z(Z3) und der Summe der beiden Meßwerte Z(Z2) und Z(Z3) ein digitales Datenwortsignal SQ erzeugt werden, wobei dann dieses erzeugte digitale Datenwortsignal SQ das Widerstandsverhältnis R1:R zwischen dem einen Widerstandsteil R1 und dem Gesamtwiderstand R des Einstellreglers beziehungsweise das Widerstandsverhältnis R2:R zwischen dem anderen Widerstandsteil R2 und dem Gesamtwiderstand R des Einstellreglers repräsentiert.

In Fig.3 ist eine weitere Schaltungsanordnung 1 gemäß einem zweiten Ausführungsbeispiel mit einem Einstellregler 2 dargestellt, die eine Abwandlung gegenüber der Schaltungsanordnung gemäß Fig.1 darstellt. Bei der Schaltungsanordnung 1 gemäß Fig.3 sind die beiden Endanschlüsse 3 und 4 des EinStellreglers 2 je mit einem von zwei Anschlüssen 6 und 7 eines Mikroprozessors 8 verbunden, bei denen es sich um unidirektionale Signalanschlüsse handelt, die nur als Eingänge verwendbar sind. Mit den beiden Anschlüssen 6 und 7 ist je ein Mikroprozessorinterner Spannungskomparator 13 bzw. 14 verbunden. Mit den Anschlüssen 6 und 7 ist weiters je ein schematisch dargestellter, gegenüber dem Mikroprozessor 8 externer Schalter 41 bzw. 42 verbunden. Die beiden Schalter 41 und 42 können beispielsweise durch Schalttransistoren gebildet sein. Die beiden Schalter·41 und 42 sind an ihren von den Anschlüssen 6 und 7 abgewandten Enden je mit dem ersten Potential V1 verbunden. Die beiden Schalter 41 und 42 sind durch den Mikroprozessor 8 steuerbar, wofür die Steuereingänge dieser beiden Schalter 41 und 42 mit je einem von zwei weiteren Anschlüssen 43 und 44 des Mikroprozessors 8 verbunden sind. Bei den beiden Anschlüssen 43 und 44 handelt es sich um unidirektionale Signalanschlüsse, die nur als Ausgänge verwendbar sind.

Bei der Schaltungsanordnung 1 gemäß Fig.3 sind die mit den Endanschlüssen 3 und 4 des Einstellreglers 2 verbundenen Widerstände 15 und 16 an ihren vom Einstellregler 2 abgewandten Enden je mit dem zweiten Potential V2 verbunden. Der vom Schleifer 5 des Einstellreglers 2 abgewandte Anschluß 19 des Kondensators 18 ist mit dem ersten Potential V1 verbunden, könnte aber auch mit einem von dem ersten Potential V1 abweichenden Potential verbunden sein.

Zur Erzeugung eines das jeweils eingestellte Widerstandsverhältnis repräsentierenden digitalen Signales ist der Mikroprozessor 8 der Schaltungsanordnung 1 gemäß Fig.3 zur Durchführung eines Programmablaufes ausgebildet, der im folgenden anhand des in Fig.4 dargestellten Flußdiagrammes 45 beschrieben ist.

Beim Block 46 wird dieser Programmablauf gestartet. Beim nachfolgenden Block 47 gibt der Mikroprozessor 8 an seinem Ausgang 43 ein Steuersignal ab, das den Schalter 41 in seinen nichtleitenden Zustand steuert, wodurch an den einen Anschluß 6 des Mikroprozessors 8 und an den einen Endanschluß 3 des Einstellreglers 2 über den Widerstand 15 das zweite Potential V2 angeschaltet wird. Beim nachfolgenden Block 48 gibt der Mikroprozessor 8 an seinem Ausgang 44 ein Steuersignal ab, das den Schalter 42 in seinen nichtleitenden Zustand steuert, wodurch an den anderen Anschluß 7 des Mikroprozessors 8 und an den anderen Endanschluß 4 des Einstellreglers 2 über den Widerstand 16 das zweite Potential V2 angeschaltet wird. Danach wird beim Block 49 analog wie beim Block 24 gemäß Fig.2 ein interner Zeitgeber Z1 für eine vorgegebene Zeitspanne T1 gestartet. Durch das Anschalten des zweiten Potentiales V2 an die beiden Endanschlüsse 3 und 4 des Einstellreglers 2 wird der Kondensator 18 relativ rasch geladen und dadurch in einen Ausgangsladezustand gebracht, in dem sein Ansluß 19 das erste Potential V1 und sein Anschluß 17 das zweite Potential V2 aufweist.

Nach Ablauf der vorgegebenen Zeitspanne T1 gibt beim Block 50 der Mikroprozessor 8 an seinem Ausgang 43 ein Steuersignal ab, das den Schalter 41 in seinen leitenden Zustand steuert, wodurch an den einen Anschluß 6 des Mikroprozessors 8 und an den einen Endanschluß 3 des Einstellreglers 2 das erste Potential V1 angeschaltet wird, dies zum Umladen des Kondensators 18 über den zwischen diesem einen Anschluß 6 und dem Schleifer 5 liegenden einen Widerstandsteil R1 des Einstellreglers 2 und den nunmehr leitenden Schalter 41. Durch dieses Umladen des Kondensators 18 wird derselbe entladen und nimmt daher das Potential am Anschluß 17 desselben zu. Beim nachfolgenden Block 51 wird analog zum Block 26 gemäß Fig.2 ein Zeitzähler Z2 gestartet. Danach wird beim Block 52 analog wie beim Block 27 gemäß Fig.2 geprüft, ob das an dem anderen Anschluß 7 des Mikroprozessors 8 auftretende Potential das vorgegebene Referenzpotential V1/2 erreicht hat. Solange dies nicht der Fall ist, wird der Programmablauf beim Block 52 fortgesetzt. Wenn dies jedoch der Fall ist, wird der Programmablauf beim Block 53 fortgesetzt, bei dem der Zeitzähler Z2 gestoppt wird, der dann einen bestimmten Zählerstand Z(Z2) aufweist. Danach wird beim Block 54 der Zählerstand Z(Z2) des Zeitzählers Z2 in einem Register RG1 gespeichert. Der gespeicherte Zählerstand Z(Z2) stellt einen ersten Meßwert dar. Dieser erste Meßwert entspricht einer zu dem Widerstandswert des einen Widerstandsteiles R1 und dem Kapazitätswert des Kondensators 18 proportionalen ersten Umladezeitspanne TU1, die vom Startzeitpunkt des Umladens bis zu einem Zeitpunkt verstreicht, zu dem das Potential an dem mit dem Schleifer 5 verbundenen Anschluß 17 des Kondensators 18 den vorgegebenen Potentialwert V1/2 erreicht hat.

Danach gibt beim Block 55 der Mikroprozessor 8 an seinem Ausgang 43 ein Steuersignal ab, das den Schalter 41 in seinen nichtleitenden Zustand steuert, wodurch an den einen Anschluß 6 des Mikroprozessors 8 und an den einen Endanschluß 3 des Einstellreglers 2 über den Widerstand 15 wieder das zweite Potential V2 angeschaltet wird. Da hiebei auch der Schalter 42 sich in seinem nichtleitenden Zustand befindet, wodurch an den anderen Anschluß 7 des Mikroprozessors 8 und an den anderen Endanschluß 4 des Einstellreglers 2 über den Widerstand 16 ebenfalls das zweite Potential V2 angeschaltet ist, wird der Kondensator 18 wieder relativ rasch geladen und dadurch wieder in seinen Ausgangsladezustand gebracht. Beim nachfolgenden Block 56 wird analog wie beim Block 49 der interne Zeitgeber Z1 für die vorgegebene Zeitspanne T1 gestartet.

Nach Ablauf der vorgegebenen Zeitspanne T1 gibt beim Block 57 der Mikroprozessor 8 an seinem Ausgang 44 ein Steuersignal ab, das den Schalter 42 in seinen leitenden Zustand steuert, wodurch an den anderen Anschluß 7 des Mikroprozessors 8 und an den anderen Endanschluß 4 des Einstellreglers 2 das erste Potential V1 angeschaltet wird, dies zum Umladen des Kondensators 18 über den zwischen diesem anderen Anschluß 7 und dem Schleifer 5 liegenden Widerstandsteil R2 des Einstellreglers 2 und den nunmehr leitenden Schalter 42. Bei diesem Umladevorgang wird der Kondensator 18 entladen und somit steigt das Potential an dem Anschluß 17 des Kondensators 18 an. Beim nachfolgenden Block 58 wird analog wie beim Block 33 gemäß Fig.2 ein Zeitzähler Z3 gestartet. Danach wird beim Block 59 analog wie beim Block 34 gemäß Fig.2 geprüft, ob das an dem einen Anschluß 6 des Mikroprozessors 8 auftretende Potential das vorgegebene Referenzpotential V1/2 erreicht hat. Solange dies nicht der Fall ist, wird der Programmablauf beim Block 59 fortgesetzt. Ist dies jedoch der Fall, wird der Programmablauf beim Block 60 fortgesetzt. Beim Block 60 wird der Zeitzähler Z3 gestoppt, der dann einen bestimmten Zählerstand Z(Z3) aufweist. Danach wird beim Block 61 der Zählerstand Z(Z3) des Zeitzählers Z3 in einem Register RG2 gespeichert. Der gespeicherte Zählerstand Z(Z3) stellt einen zweiten Meßwert dar. Dieser zweite Meßwert entspricht einer zu dem Widerstandswert des anderen Widerstandsteiles R2 und dem Kapazitätswert des Kondensators 18 proportionalen zweiten Umladezeitspanne TU2, die vom Startzeitpunkt des Umladens bis zu einem Zeitpunkt verstreicht, zu dem das Potential an dem mit dem Schleifer 5 verbundenen Anschluß 17 des Kondensators 18 den vorgegebenen Potentialwert V1/2 erreicht hat. Beim nachfolgenden Block 62 gibt der Mikroprozessor 8 an seinem Ausgang 44 ein Steuersignal ab, das den Schalter 42 wieder in seinen nichtleitenden Zustand steuert, wodurch an den anderen Anschluß 7 des Mikroprozessors 8 und an den anderen Endanschluss 4 des Einstellreglers 2 über den Widerstand 16 wieder das zweite Potential V2 angeschaltet wird.

Beim nachfolgenden Block 63 wird unter Verwendung des beim Block 54 im Register RG1 gespeicherten ersten Meßwertes Z(Z2) und des beim Block 61 im Register RG2 gespeicherten zweiten Meßwertes Z(Z3) durch Quotientenbildung aus dem ersten Meßwert Z(Z2) und dem zweiten Meßwert Z(Z3) ein digitales Datenwortsignal SQ erzeugt. Beim nachfolgenden Block 64 wird das erzeugte digitale Datenwortsignal SQ in einem Register RG3 gespeichert. Dieses Datenwortsignal SQ, das in vorliegendem Fall mit Hilfe des Quotienten aus dem zu dem einen Widerstandsteil R1 proportionalen ersten Meßwert Z(Z2) und dem zu dem anderen Widerstandsteil R2 proportionalen zweiten Meßwert Z(Z3) erzeugt wurde, repräsentiert das mit dem Schleifer 5 eingestellte Widerstandsverhältnis R1:R2 zwischen dem einen Widerstandsteil R1 und dem anderen Widerstandsteil R2 des Einstellreglers 2. Beim nachfolgenden Block 65 wird der Programmablauf 45 gemäß Fig.4 beendet.

An dieser Stelle sei erwähnt, daß die Schalter 41 und 42 und der Kondensator 18 mit seinem Anschluß 19 nicht unbedingt an das erste Potential V1, das dem Mikroprozessor 8 an seinem Anschluß 9 als Versorgungspotential zugeführt ist, und die Widerstände 15 und 16 nicht unbedingt an das zweite Potential V2, das dem Mikroprozessor 8 an seinem Anschluß 10 als Bezugspotential zugeführt ist, angeschlossen sein müssen. Beispielsweise könnten die Schalter 41 und 42 auch an ein Potential V3, die Widerstände 15 und 16 an ein Potential V4 und der Kondensator 18 mit seinem Anschluß 19 an ein Potential V5 angeschlossen sein, wie dies in Fig.3 angegeben ist.

In Fig.5 ist eine Schaltungsanordnung 1 gemäß einem dritten Ausführungsbeispiel dargestellt, die einen Einstellregler 2 aufweist, dessen Endanschlüsse 3 und 4 ausschließlich je mit einem von zwei Anschlüssen 6 und 7 eines Mikroprozessors 8 verbunden sind. Bei diesen beiden Anschlüssen 6 und 7 handelt es sich um bidirektional verwendbare Signalanschlüsse, die sowohl als Eingänge als auch Ausgänge verwendbar sind. Mit jedem der beiden Anschlüsse 6 und 7 ist ein mikroprozessorinterner Komparator 13 bzw. 14 verbunden. Mit den Anschlüssen 6 und 7 sind weiters je zwei Schalter 66 und 67 bzw. 68 und 69 verbunden. Die Schalter 66, 67, 68 und 69 sind dabei auf einfache Weise durch mikroprozessorinterne Transistoren gebildet. Der Schalter 66 und der Schalter 68 sind an ihren von den Anschlüssen 6 bzw. 7 abgewandten Enden je mit dem ersten Potential V1 verbunden. Der Schalter 67 und der Schalter 69 sind an ihren von den Anschlüssen 6 bzw. 7 abgewandten Enden je mit dem zweiten Potential V2 verbunden.

Zur Erzeugung eines das jeweils eingestellte Widerstandsverhältnis repräsentierenden digitalen Signales ist der Mikroprozessor 8 der Schaltungsanordnung 1 gemäß Fig.5 zur Durchführung eines Programmablaufes ausgebildet, der im folgenden anhand des in Fig.6 dargestellten Flußdiagrammes 70 beschrieben ist.

Beim Block 71 wird dieser Programmablauf gestartet. Dabei sei angenommen, daß beim Start dieses Programmablaufes die Schalter 66, 67, 68 und 69 sich alle in ihrem nichtleitenden Zustand befinden. Beim nachfolgenden Block 72 wird der Schalter 66 in seinen leitenden Zustand gesteuert. Beim nachfolgenden Block 73 wird der Schalter 68 in seinen leitenden Zustand gesteuert. Dadurch wird sowohl an den einen Anschluß 6 des Mikroprozessors 8 und den mit diesem verbundenen Endanschluß 3 des Einstellreglers 2 als auch an den anderen Anschluß 7 des Mikroprozessors 8 und den mit diesem verbundenen Endanschluß 4 des Einstellreglers 2 das erste Potential V1 angeschaltet. Beim nachfolgenden Block 74 wird analog wie beim Block 24 gemäß Fig.2 und beim Block 49 gemäß Fig.4 ein Zeitgeber Z1 für eine vorgegebene Zeitspanne T1 gestartet. Durch das Anschalten des ersten Potentiales V1 an die beiden Endanschlüsse 3 und 4 des Einstellreglers 2 wird der Kondensator 18 sowohl über den einen Widerstandsteil R1 als auch über den anderen Widerstandsteil R2 rasch geladen und damit in einen Ausgangsladezustand gebracht, in dem der Anschluß 17 desselben das erste Potential V1 und der Anschluß 19 desselben das zweite Potential V2 aufweist. Nach Ablauf der vorgegebenen Zeitspanne T1 wird beim Block 75 der Schalter 66 in seinen nichtleitenden Zustand gesteuert. Beim nachfolgenden Block 76 wird der Schalter 68 in seinen nichtleitenden Zustand gesteuert. Hiedurch wird das erste Potential V1 von den Anschlüssen 6 und 7 des Mikroprozessors 8 und den mit diesen verbundenen Endanschlüssen 3 und 4 des Einstellreglers 2 weggeschaltet.

Beim nachfolgenden Block 77 wird der Schalter 67 in seinen leitenden Zustand gesteuert, wodurch an den einen Anschluß 6 des Mikroprozessors 8 und an den mit diesem verbundenen einen Endanschluß 3 des Einstellreglers 2 das zweite Potential V2 angeschaltet wird, dies zum Umladen des Kondensators 18 über den zwischen diesem einen Anschluß 6 und dem Schleifer 5 liegenden einen Widerstandsteil R1 des Einstellreglers 2 und den nunmehr leitenden Schalter 67. Durch dieses Umladen wird der Kondensator 18 entladen, wobei das Potential an dem mit dem Schleifer 5 verbundenen Anschluß 17 des Kondesators 18 sinkt. Beim nachfolgenden Block 78 wird analog wie beim Block 26 gemäß Fig.2 und beim Block 51 gemäß Fig.4 ein Zeitzähler Z2 gestartet. Beim nachfolgenden Block 79 wird geprüft, ob das an dem anderen Anschluß 7 des Mikroprozessor 8 auftretende Potential, das dem Potential an dem mit dem Schleifer 5 verbundenen Anschluß 17 des Kondensators 18 entspricht, das vorgegebene Referenzpotential V1/2 erreicht hat. Solange dies nicht der Fall ist, wird der Programmablauf beim Block 79 fortgesetzt. Wenn dies jedoch der Fall ist, wird der Programmablauf beim Block 80 fortgesetzt, bei dem der Zeitzähler Z2 gestoppt wird, der dann einen bestimmten Zählerstand Z(Z2) aufweist. Danach wird beim Block 81 der Zählerstand Z(Z2) des Zeitzählers Z2 in einem Register RG1 gespeichert. Der gespeicherte Zählerstand Z(Z2) stellt einen ersten Meßwert dar. Dieser erste Meßwert entspricht einer zum Widerstandswert des einen Widerstandsteiles R1 und dem Kapazitätswert des Kondensators 18 proportionalen ersten Umladezeitspanne TU1, die vom Startzeitpunkt des Umladens bis zu einem Zeitpunkt verstreicht, zu dem das Potential an dem mit dem Schleifer 5 verbundenen Anschluß 17 des Kondensators 18 den vorgegebenen Potentialwert V1/2 erreicht hat. Beim nachfolgenden Block 82 wird der Schalter 67 wieder in seinen nichtleitenden Zustand gesteuert, wodurch von dem einen Anschluß 6 des Mikroprozessors 8 und dem mit diesem verbundenen einen Endanschluß 3 des Einstellreglers 2 das zweite Potential V2 weggeschaltet wird.

Beim nachfolgenden Block 83 wird analog wie beim Block 72 der Schalter 66 in seinen leitenden Zustand gesteuert. Danach wird beim Block 84 analog wie beim Block 73 der Schalter 68 in seinen leitenden Zustand gesteuert. Danach wird beim Block 85 analog wie beim Block 74 der Zeitgeber Z1 für die vorgegebene Zeitspanne T1 gestartet. Durch das Abarbeiten der Blöcke 83, 84 und 85 wird an die Anschlüsse 6 und 7 des Mikroprozessors 8 und die mit diesen verbundenen Endanschlüsse 3 und 4 des Einstellreglers 2 wieder das erste Potential V1 angeschaltet und über die Widerstandteile R1 und R2 der Kondensator 18 rasch geladen und damit in seinen Ausgangsladezustand gebracht, bei dem der Anschluß 17 das erste Potential V1 und der Anschluß 19 das zweite Potential V2 aufweist. Nach Ablauf der vorgegebenen Zeitspanne T1 wird beim Block 86 analog wie beim Block 75 der Schalter 66 wieder in seinen nichtleitenden Zustand gesteuert. Beim nachfolgenden Block 87 wird analog wie beim Block 76 der Schalter 68 in seinen nichtleitenden Zustand gesteuert. Durch das Abarbeiten der Blöcke 86 und 87 wird das erste Potential V1 von den Anschlüssen 6 und 7 des Mikroprozessors 8 und den mit diesen verbundenen Endanschlüssen 3 und 4 des Einstellreglers 2 weggeschaltet.

Beim nachfolgenden Block 88 wird der Schalter 69 in seinen leitenden Zustand gesteuert, wodurch an den anderen Anschluß 7 des Mikroprozessors 8 und den mit diesem verbundenen anderen Endanschluß 4 des Einstellreglers 2 das zweite Potential V2 angeschaltet wird, dies zum Umladen des Kondensators 8 über den zwischen diesem anderen Anschluß 7 und dem Schleifer 5 liegenden anderen Widerstandteil R2 des Einstellreglers 2 und den nunmehr leitenden Schalter 69. Hiedurch wird der Kondensator 18 entladen, wobei das Potential an seinem mit dem Schleifer 5 verbundenen Anschluß 17 sinkt. Beim nachfolgenden Block 89 wird ein Zeitzähler Z3 gestartet. Beim nachfolgenden Block 90 wird geprüft, ob das an dem einen Anschluß 6 des Mikroprozessors 8 auftretende Potential, das hiebei dem Poten tial an dem mit dem Schleifer 5 verbundenen Anschluß 17 des Kondensator 18 entspricht, das vorgegebene Referenzpotential V1/2 erreicht hat. Solange dies nicht der Fall ist, wird der Programmablauf beim Block 90 fortgesetzt. Ist dies jedoch der Fall, dann wird der Programmablauf beim Block 91 fortgesetzt, bei dem der Zeitzähler Z3 gestoppt wird, der dann einen bestimmten zählerstand Z(Z3) aufweist. Danach wird beim Block 92 der Zählerstand Z(Z3) des Zeitzählers Z3 in einem Register RG2 gespeichert. Der gespeicherte Zählerstand Z(Z3) stellt einen zweiten Meßwert dar. Dieser zweite Meßwert entspricht einer zum Widerstandswert des anderen Widerstandteiles R2 und dem Kapazitätswert des Kondensators 18 proportionalen zweiten Umladezeitspanne TU2, die vom Startzeitpunkt des Umladens bis zu einem Zeitpunkt verstreicht, zu dem das Potential an dem mit dem Schleifer 5 verbundenen Anschluß 17 des Kondensators 18 den vorgegebenen Potentialwert V1/2 erreicht hat. Beim nachfolgenden Block 93 wird der Schalter 69 wieder in seinen nichtleitenden Zustand gesteuert, wodurch von dem anderen Anschluß 7 des Mikroprozessors 8 und dem mit diesem verbundenen anderen Endanschluss 4 des Einstellreglers 2 das zweite Potential V2 weggeschaltet wird.

Beim nachfolgenden Block 94 wird unter Verwendung des beim Block 81 im Register RG1 gespeicherten ersten Meßwertes Z(Z2) und des beim Block 92 im Register RG2 gespeicherten zweiten Meßwertes Z(Z3) durch Quotientenbildung aus dem ersten Meßwert Z(Z2) und dem zweiten Meßwert Z(Z3) ein digitales Datenwortsignal SQ erzeugt. Beim nachfolgenden Block 95 wird das erzeugte digitale Datenwortsignal SQ in einem Register RG3 gespeichert. Dieses digitale Datenwortsignal SQ, das mit Hilfe des Quotienten aus dem zu dem einen Widerstandteil R1 proportionalen ersten Meßwert Z(Z2) und dem zu dem anderen Widerstandteil R2 proportionalen zweiten Meßwert Z(Z3) erzeugt wurde, repräsentiert das mit dem Schleifer 5 eingestellte Widerstandsverhältnis R1:R2 zwischen dem einen Widerstandteil R1 und dem anderen Widerstandteil R2 des Einstellreglers 2. Beim nachfolgenden Block 96 wird der Programmablauf 70 gemäß Fig.6 beendet.

Zur Erzeugung eines das jeweils eingestellte Widerstandsverhältnis repräsentierenden digitalen Signales könnte der Mikroprozessor 8 der Schaltungsanordnung 1 gemäß Fig. 5 auch zur Durchführung eines Programmblaufes ausgbildet sein, der im folgenden anhand des in Fig.7 dargestellten Flußdiagrammes 97 beschrieben ist.

Dieser Programmablauf wird beim Block 98 gestartet. Beim Block 99 wird der Schalter 67 in einen leitenden Zustand gesteuert. Beim Block 100 wird der Schalter 69 in seinen leitenden Zustand gesteuert. Danach wird beim Block 101 ein Zeitgeber Z1 für die vorgegebene Zeitspanne, T1 gestartet. Durch Abarbeiten der Blöcke 99, 100 und 101 wird an die Anschlüsse 6 und 7 des Mikroprozessors 8 das zweite Potential V2 angeschaltet und dadurch der Kondensator 18 in diesem Fall durch Entladen desselben rasch in einen Ausgangsladezustand gebracht, bei dem seine beiden Anschlüsse 17 und 19 je das zweite Potential V2 aufweisen.

Beim nachfolgenden Block 102 wird der Schalter 67 wieder in seinen nichtleitenden Zustand gesteuert. Beim nachfolgenden Block 103 wird der Schalter 69 in seinen nichtleitenden Zustand gesteuert. Durch Abarbeiten der Blöcke 102 und 103 wird das zweite Potential V2 von den Anschlüssen 6 und 7 des Mikroprozessors 8 weggeschaltet.

Beim nachfolgenden Block 104 wird dr Schalter 66 in seinen leitenden Zustand gesteuert, wodurch an den einen Anschluß 6 des Mikroprozessors 8 das erste Potential V1 angeschaltet wird und über den Schalter 66 und deti einen Widerstandsteil R1 der Kondensator 16 rasch geladen wird, wobei das Potential an seinem Anschluß 17 steigt. Danach wird beim Block 105 ein Zeitzähler Z2 gestartet. Danach wird beim Block 106 geprüft, ob das am anderen Anschluß 7 des Mikroprozessors 8 auftretende Potential das vorgegebene Referenzpotential V1/2 erreicht hat. Solange dies nicht der Fall ist, wird der Programmablauf beim Block 106 fortgesetzt. Ist dies jedoch der Fall, wird der Programmablauf beim Block 107 fortgesetzt, bei dem der Zeitzähler Z2 gestoppt wird der dann einen bestimmten Zählerstand Z(Z2) aufweist. Beim nachfolgenden Block 108 wird der Zahlerstand Z(Z2) des Zeitzählers Z2 in einem Register RG1 gespeichert. Der Zählerstand Z(Z2) stellt einen ersten Meßwert dar, wie dies bereits anhand des Blockes 81 gemäß Fig.6 erläutert wurde. Danach wird beim Block 109 der Schalter 66 wieder in seinen nichtleitenden Zustand gesteu ert, wodurch das erste Potential V1 von dem einen Anschluß 6 des Mikroprozessors 8 weggeschaltet wird.

Danach wird beim Block 110 der Schalter 67 wieder in seinen leitenden Zustand gesteuert. Danach wird beim Block 111 ert. Danach wird beim Block 112 der Zeitgeber Z1 für die vorder Schalter 69 wieder in seinen leitenden Zustand gesteugegebene Zeitspanne T1 gestartet. Durch Abarbeiten der Blöcke 110, 111 und 112 wird an die Anschlüsse 6 und 7 des Mikroprozessors 8 wieder das zweite Potential V2 angeschaltet und dadurch der Kondensator 18 rasch entladen und wieder in seinen Ausgangsladezustand gebracht, bei dem eine beiden Anschlüsse 17 und 19 je das zweite Potential V2 aufweisen. Danach wird beim Block 113 der Schalter 67 wieder in seinen nichtleitenden Zustand gesteuert. Danach wird beim Block 114 der Schalter 69 wieder in seinen nichtleitenden Zustand gesteuert. Durch Abarbeiten der Blöcke 113 und 114 wird das zweite Poiential V2 von den Anschlüssen 6 und 7 des Mikroprozessors 8 weggeschaltet.

Beim nachfolgenden Block 115 wird, der Schalter 68 in sainen leitenden Zustand gesteuert. Dadurch wird über den Schalter 68 das erste Potential V1 an den anderen Anschluß 7 des Mikroprozessors 8 angeschaltet und über den Schalter 68 und den anderen Widerstandsteil R2 der Kondensator 18 rasch geladen, wobei das Potential an seinem Anschluß 17 steigt. Danach wird beim Block 116 ein Zeitzähler Z3 gestartet. Danach wird beim Block 117 geprüft, ob das an dem einen Anschluß 6 des Mikroprozessois 8 auftretende Potential das vorgegebene Referenzpotential V1/2 erreicht hat. Solaige dies nicht der Fall ist, wird der Programmablauf beim Block 117 fortgesetzt. Ist dies jedoch der Fall, dann wird der Programmablauf beim Block 118 fortgesetzt, bei dem der Zeitzähler Z3 gestoppt wird, der dann einen bestimmten Zählerstand Z(Z3) aufweist. Danach wird beim Block 119 der Zählerstand Z(Z3) des Zeitzählers Z3 in einem Register RG2 gespeichert. Der gespeicherte Zählerstand Z(Z3) stellt einen zweiten Meßwert dar, wie dies bereits anhand des Blockes 92 gemäß Fig.6 erläutert ist. Beim nachfolgenden Block 120 wird der Schalter 68 wieder in seinen nichtleitenden Zustand gesteuert, wodurch das erste Potential V1 von dem anderen Anschluß 7 des Mikroprosessors 8 weggeschal tet wird.

Beim nachfolgenden Block 121 wird unter Verwendung des beim Block 108 im Register RG1 gespeicherten ersten Meßwertes Z(Z2) und des beim Block 119 im Register RG2 gespeicherten zweiten Meßwertes Z(Z3) durch Quotientenbildung aus dem er sten Meßwert Z(Z2) und dem zweiten Meßwert Z(Z3) ein digitales Datenwortsignal SQ erzeugt. Beim nachfolgenden Block 122 wird das erzeugte digitale Datenwortsignal SQ in einem Register RG3 gespeichert. Dieses digitale Datenwortsignal SQ repräsentiert wieder das mit dem Schleifer 5 eingestellte Widerstandsverhältnis R1:R2 zwischen dem einen Widerstandteil R1 und dem anderen Widerstandsteil R2 des Einstellreglers 2. Beim nachfolgenden Block 123 wird der Programmablauf 97 gemäß Fig.7 beendet.

Wie aus den Figuren 1, 3 und 5 ersichtlich, weisen die vorstehend beschriebenen Schaltungsanordnungen, mit denen je ein das jeweils eingestellte Widerstandsverhaltnis des Einstellreglers repräsentierendes digitales Signal erzeugbar ist, eine mehr einfache Ausbildung auf, die zusätzlich auch sehr preiswert ist, da ein für andere Zwecke in einem Gerät beziehungsweise in einer Einrichtung ohnehin vorgeschener Mikro prozessor zur Erzeugung des digitalen Signales, das ein eingestelltes Widerstandsverhältnis repräsentiert, ausgenützt wird.

**Ansprüche**

1. Schaltungsanordnung mit einem Einstellregler, der zwei Endanschlüsse und einen zwischen den beiden Endanschlüssen verstellbaren Schleifer zum Einstellen unterschiedlicher Widerstandsverhältnisse aufweist, mit der ein ein mit dem Schleifer eingestelltes Widerstandsverhältnis repräsentierendes elektrisches Signal erzeugbar ist, dadurch gekennzeichnet, dass die beiden Endanschlüsse des Einstellreglers je mit einem von zwei Anschlüssen eines Mikroprozessors verbunden sind und der Schleifer des Einstellreglers mit einem Anschluss eines Kondensators verbunden ist, dessen anderer Anschluss mit einem vorgegebenen Potential verbunden ist, und dass mit jedem der beiden Anschlüsse des Mikroprozessors mindestens ein durch den Mikroprozessor steuerbarer Schalter verbunden ist, mit dem wahlweise ein erstes Potential oder ein zweites Potential an den mit ihm verbundenen Anschluss anschaltbar ist, und dass der Mikroprozessor zur Durchführung eines Programmablaufes ausgebildet ist, bei dem aufeinanderfolgend in einem ersten Programmabschnitt an mindestens einen der beiden Anschlüsse mit dem mit diesem verbundenen Schalter eines von dem ersten und zweiten Potential für eine vorgegebene Zeitspanne angeschaltet wird, wobei der Kondensator in einen Ausgangsladezustand gebracht wird, in einem zweiten Programmabschnitt an einen der beiden Anschlüsse mit dem mit diesem verbundenen Schalter das andere von dem ersten und zweiten Potential zum Umladen des Kondensators über den zwischen diesem einen Anschluss und dem Schleifer liegenden einen Widerstandteil des Einstellreglers angeschaltet wird und ein erster Messwert ermittelt und gespeichert wird, der einer zum Wert dieses einen Widerstandteiles proportionalen ersten Umladezeitspanne vom Startzeitpunkt des Umladens bis zu einem Zeitpunkt, zu dem das Potential an dem mit dem Schleifer verbundenen Anschluss des Kondensators einen vorgegebenen Potentialwert erreicht, entspricht, in einem dritten Programmabschnitt an mindestens einen der beiden Anschlüsse mit dem mit diesem verbundenen Schalter wieder das eine von dem ersten und zweiten Potential für die vorgegebene Zeitspanne angeschaltet wird, wobei der Kondensator wieder in den Ausgangsladezustand gebracht wird, in einem vierten Programmabschnitt an den anderen der beiden Anschlüsse mit dem mit diesem verbundenen Schalter das andere von dem ersten und zweiten Potential zum Umladen des Kondensators über den zwischen diesem anderen Anschluss und dem Schleifer liegenden anderen Widerstandsteil des Einstellreglers angeschaltet wird und ein zweiter Messwert ermittelt und gespeichert wird, der einer zum Wert dieses anderen Widerstandsteiles proportionalen zweiten Umladezeitspanne vom Startzeitpunkt des Umladens bis zu einem Zeitpunkt, zu dem das Potential an dem mit dem Schleifer verbundenen Anschluss des Kondensators wieder den vorgegebenen Potentialwert erreicht, entspricht, und in einem fünften Programmabschnitt unter Verwendung des gespeicherten ersten Messwertes und des gesprecherten zweiten Messwertes durch Quotientenbildung ein digitales Datenwortsignal erzeugt und gespeichert wird, das ein mit dem Schleifer des Einstellreglers eingestelltes Widerstandsverhältnis repräsentiert.

2. Schaltungsanordnung nach Anspruch 1, dadurch gekennzeichnet, dass der Mikroprozessor zur Durchführung eines Programmablaufes ausgebildet ist, bei dem in dem ersten Programmabschnitt und in dem dritten Programmabschnitt an beide Anschlüsse des Mikroprozessors mit den mit diesen Anschlüssen verbundenen schaltern das eine von dem ersten und zweiten Potential für eine vorgegebene Zeitspanne angeschaltet wird, wobei der Kondensator in seinen Ausgangsladezustand gebracht wird.

3. Schaltungdanordnung nach Anspruch 1 oder 2, dadurch gekennzeichnet, dass die beiden Endanschlüsse des Einstellreglers je über einen Widerstand an eines von dem ersten und zweiten Potential fix angeschlossen sind und an jedem der beiden mit den Endanschlüssen verbundenen Anschlüsse des Mikroprozessors über bur einen Schalter je Anschluss das andere von dem ersten und zweiten Potential anschaltbar ist.

4. Schaltungsanordnung nach einem der vorhergehenden Ansprüche, dadurch gekennzeichnet, dass die mit den beiden Anschlüssen des Mikroprozessors verbundenen Schalter durch mikroprozessorinterne Transistoren gebildet sind.

**FIG.1**

**FIG.2**

FIG.3

FIG.4

FIG.5

FIG.6

FIG.7